# EUROPEAN PATENT SPECIFICATION

(11) **EP 4 575 600 B1**
(45) Date of publication and mention of the grant of the patent: **02.12.2026**
(21) Application number: 24213289.2
(22) Date of filing: 15.11.2024
(51) Int. Cl.: G02B 6/42, G02B 6/43, G02B 6/138

(54) **PATTERNABLE BOND-DEBOND PROCESSES AND APPARATUSES**
MUSTERBARE BOND-DEBOND-VERFAHREN UND VORRICHTUNGEN
PROCÉDÉS ET APPAREILS DE DÉSOUDAGE PAR LIAISON POUVANT ÊTRE FORMÉE PAR MOTIFS

(30) Priority: 20.12.2023 US 202318389808
(43) Date of publication of application: 25.06.2025
(73) Proprietor: INTEL Corporation, Santa Clara, CA 95054 (US)
(72) Inventor: ARRINGTON, Clay, Queen Creek, 85142 (US); SHAN, Bohan, Chandler, 85226 (US); XU, Dingying, Chandler, 85248 (US); CROISSANT, Jonas, Maricopa, 85138 (US); BRUN, Xavier, Chandler, 85224 (US); PATEL, Jigneshkumar, Chandler, 85226 (US)
(74) Representative: HGF

(56) References cited:
- US-A1- 2009 226 848
- US-A1- 2023 081 194
- US-A1- 2023 136 046

## Description

### TECHNICAL FIELD

Embodiments of the invention relate to the field of integrated circuit manufacturing; and more specifically, to the field of temporary bond de-bond processes for manufacturing assemblies.

Prior art is disclosed in US 2023/136046 A1.

### BRIEF DESCRIPTION OF THE DRAWINGS

The disclosure may best be understood by referring to the following description and accompanying drawings that are used to illustrate embodiments of the invention. In the drawings:
Figs. 1A and 1B are diagrams showing exemplary optical interconnect assemblies in accordance with some embodiments.
Fig. 2 is a hybrid schematic flow diagram showing a conventional process for manufacturing optical interconnect assemblies.
Fig. 3A is a flow diagram showing a process for creating a carrier with a patternable TBDB adhesive in accordance with some embodiments.
Fig. 3B is a flow diagram showing a process for assembling optical interconnect assemblies using a patterned TBDB carrier in accordance with some embodiments.
Figs. 4A-4E are hybrid schematic flow diagrams showing different stages of a patternable TBDB carrier in accordance with some embodiments of the flow diagram of Fig. 3A.
Figs. 4F-4J are hybrid schematic flow diagrams showing different stages of an optical interconnect during an assembly process in association with the flow diagram of Fig. 3B in accordance with some embodiments.
Fig. 5 is a top view of a patterned soft-cured TBDB carrier having a checkered adhesive pattern in accordance with some embodiments.
Fig. 6 is a top view of a patterned soft-cured TBDB carrier having a ringed adhesive pattern in accordance with some embodiments.

### DETAILED DESCRIPTION

The scope of protection of the present invention i defined by the appended independent claims.

In some embodiments, a patternable TBDB for assembling complex 3D IC/optical assemblies are provided. A patternable TBDB adhesive may be formed using silicone based TBDB adhesives with incorporated photocatalysts to allow for patterning of the TBDB adhesive layer. Implementation of photoactive catalysts or initiators for TBDB adhesives allows for obtaining mm-based cavities within adhesive coatings on wafer such as with glass wafers. For example, negative type photo patterning may be employed. to attain TBDB adhesive patterns suitable for die level reconstitution. This can enable the assembly and HVM (high volume manufacturing) production of 3D IC/optical component assemblies with incompatible dimensions while avoiding adverse contact with the carrier surface.

Multi component assemblies such as with 3D silicon photonic packages are used for a wide variety of applications such as compute devices, telecommunications, and industrial machines. They can include several different types components such as integrated circuits (ICs), sensors, MEM (micro-electrical-mechanical) devices, optical structures, and the like. They can be challenging to manufacture, however, since they are commonly formed from different materials which may or may not have similar thermal characteristics, structural integrity, or resilience against environmental conditions such as pressure and chemical or electro-magnetic exposure. They can also have dimensions that are not suited for high volume manufacturing with each other. Accordingly, some embodiments provide a way to bond together differently dimensioned components without risking destructive impact from nearby obstructions.

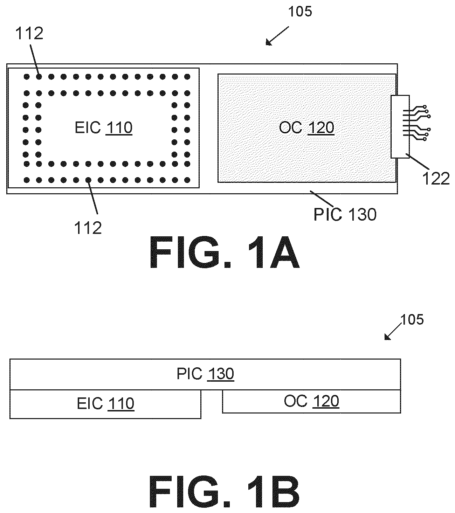

Figs 1A and 1B show an exemplary optical interconnect assembly for coupling fiber optic cable links with electronic interfaces, e.g., for connecting fiber optical links directly to server processor systems or system packages. Fig. 1A is an underside view, and Fig. 1B is a side view (neither drawn to scale). The optical interconnect assembly 105 includes an electrical interconnect (EIC) package 110, an optical coupler 120, and a photonic interconnect package 130, mounted together as shown. The EIC includes electrical contacts (bumps, micro-bumps, etc.) 112 to connect with associated contacts on a circuit board, interposer or even to another component package. The optical coupler 120 has an optical fiber cable connector 122 to receive a counterpart connector from a fiber optical cable to send receive optical signals. The PiC 130 essentially couples the EIC to the optical coupler. it has contacts (not shown) on its underside for electrical connection with the upper side of the EIC 110. It, in combination with the optical coupler, has light receptacles, amplifiers, lasers, modulators and photo-sensors for converting light signal information into electrical signals to be conveyed to the EIC and to translate electrical signals from the EIC into light signals to be sent over a connected optical cable.

Packaging such a 3D structure, however, poses unique challenges during die and component assembly. For example the optical coupler 120 is extremely fragile and may have different, e.g., thicker, dimensions than the EIC 110.

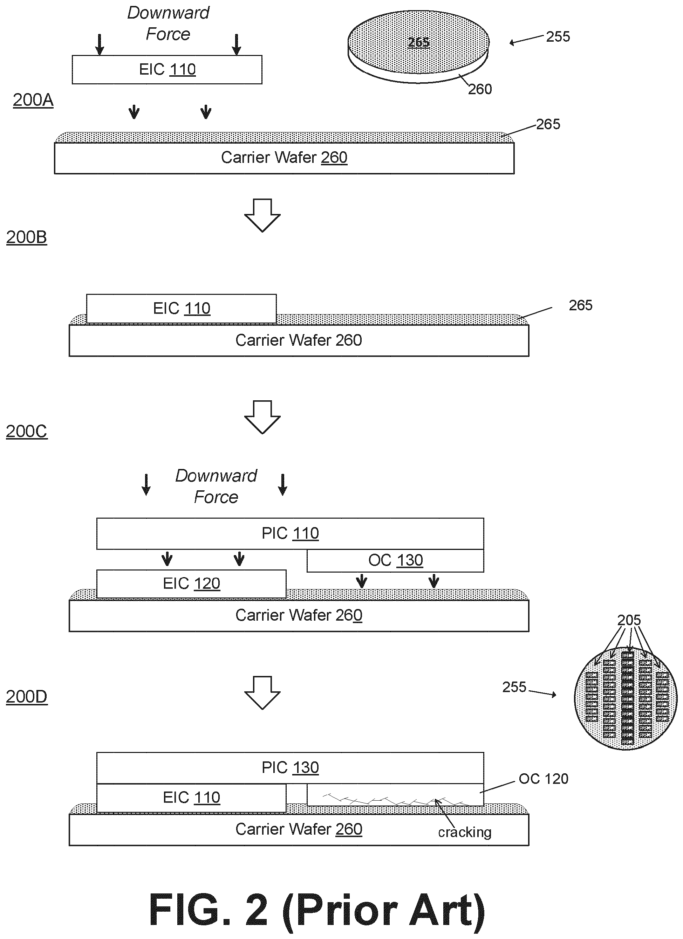

Fig. 2 is a hybrid schematic flow diagram showing a conventional process for manufacturing optical interconnect assemblies 110. A treated carrier wafer 25 is formed from applying a TBDB (temporary bond de-bond) material 265 to the surface of a carrier wafer 260. Conventional TBDB adhesives provide thin wafer carrier and die recon support during semiconductor assembly. These adhesives are typically applied as monolithic coatings on glass carriers, covering the wafer surface, and allowing for either wafer or die level bonding. These adhesives allow for assemblies to be temporarily supported and secured while being subjected to fabrication processes such as grinding, chip bonding, metallization, encapsulant dispense and thermal processing. Following desired processes, the adhesive can then be de-bonded and cleaned, leaving suitable surfaces for following packing or additional manufacturing flows.

At 200A, a side view of the carrier wafer 255 and EIC 110 are depicted. The EIC 110, with its hybrid contacts facing upward, is depressed downward onto the adhesive surface, as shown at 200B. (Note that for ease of explanation, only one assembly is shown but in a typical high volume manufacturing, HVM, scenario, many assemblies would be present on the wafer and assembled together in parallel with one another.) Observe that the EIC displaces, or compresses, the adhesive beneath its underside surface. In contrast, the adhesive next to the EIC remains at its initial thickness, e.g. tens of microns or more above the EIC underside. In addition, it may be harder, fi cured, or otherwise set for the next step.

Next, as indicated at 200C, the PIC (130)-OC(120) assembly is forced downward to mount the PIC with the upper surface of the EIC. As can be seen, the OC 120 is also brought downward and with its thicker dimension, makes contact with the adhesive. The mounted assembly is depicted at 200D. Also shown is a top view of the wafer 255 with rows of optical interconnect (OI) assemblies. Unfortunately, as is illustrate, cracking in the OC 130 can occur due to its impact with the adhesive. Catalyst raw materials for conventional TBDB adhesives typically allow only for thermal curing to form blanket coatings. The lack of catalyst variety makes it extremely difficult, if not prohibitive, to implement facile selective curing. Moreover, thinner reconstitution adhesives are not desirable because of increase die warpage and the adverse impact on coplanarity and die adhesion. Accordingly, a new approach for assembling modules using carriers with TBDB stabilization is desired.

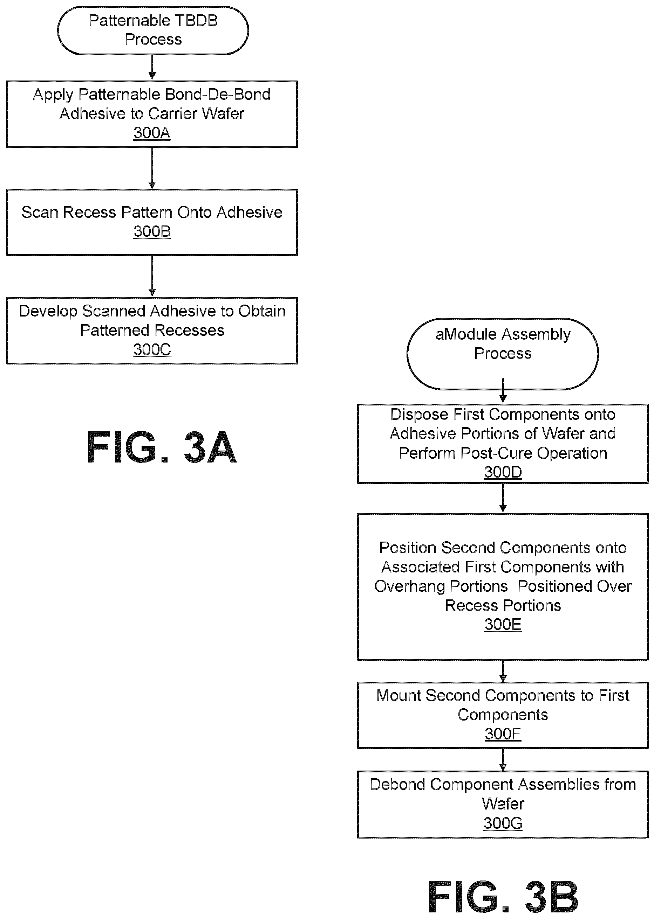

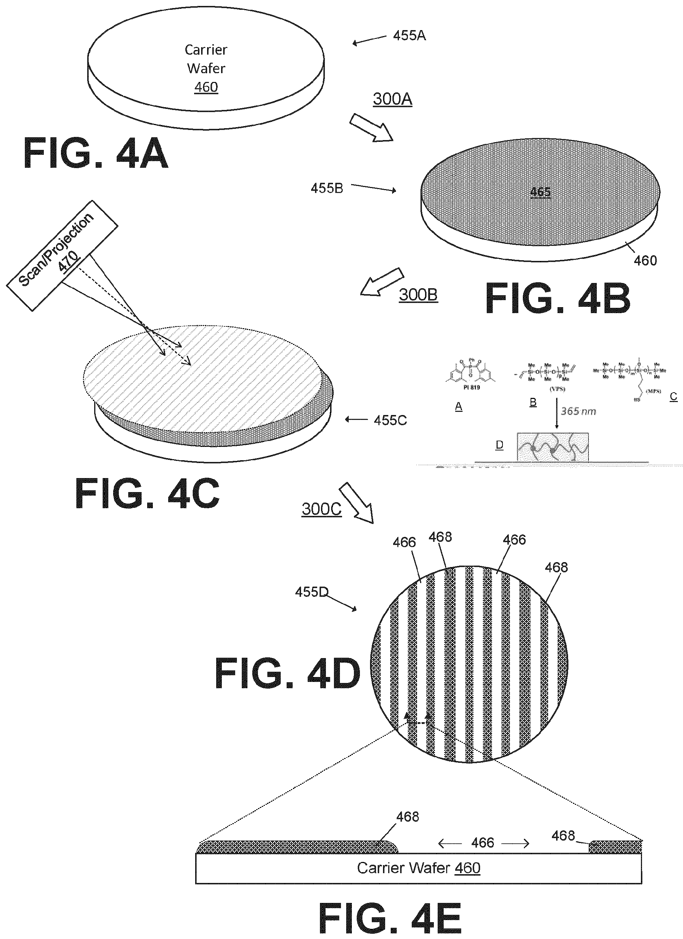

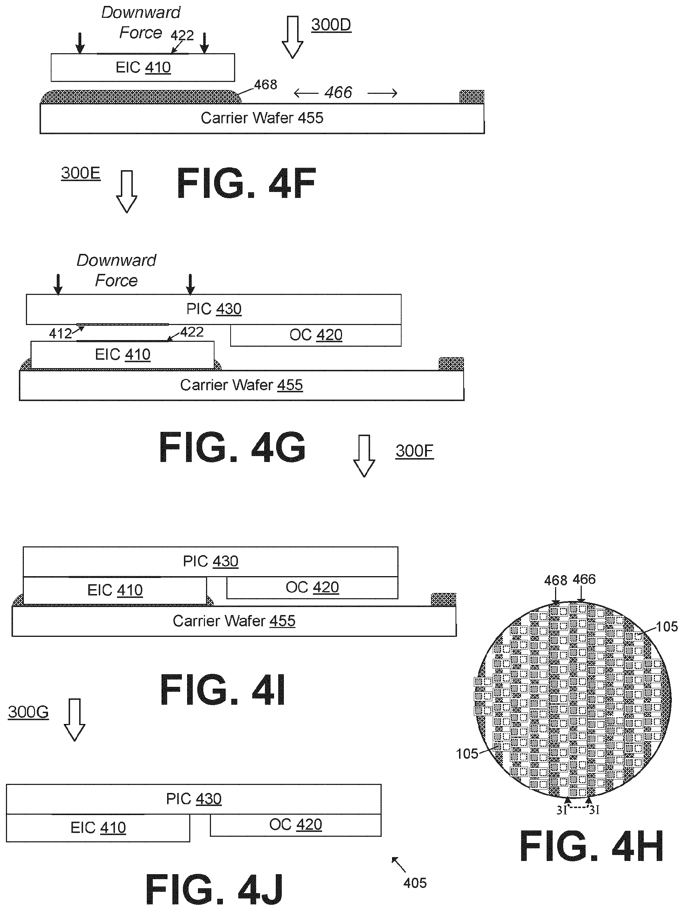

With reference to Figs 3A and 4A-4E, a process for implementing a patternable TBDB adhesive based module assembly will now be described. At 300A (Fig. 400A, 400B), a patternable TBDB adhesive 465 is applied to the surface of a carrier 460 such as a glass carrier wafer. For example, it may be spin coated or applied using another suitable manner onto the surface. The surface may be the glass carrier surface itself, or the patternable TBDB may be applied to one or more other pre-applied layers such as a release layer and/or a BARC (bottom anti-reflectant coating). The specific release mechanism will depend on the particularly utilized patternable TBDB adhesive. In some embodiments, the patternable adhesive layer may be in a range of between 50 and 100 uM in thickness.

A photoresist (also known simply as a resist) is a light-sensitive material used in several processes, such as photolithography to form a patterned coating on a surface. In some embodiments, temporary bond de-bond (TBDB) adhesives that allow for photopatterning via UV induced crosslinking are provided. A patternable TBDB adhesive may maintain existing crosslinking approaches (e.g. thermal), but also provide additional material flexibility via negative, or positive, type photo-patterning. Radical or coordination-based chemistries may be leveraged to enable patternable adhesive by paring conventional TBDB adhesives (e.g., silicone-based adhesives) with a photo-initiator.

In some embodiments, patternable TBDB adhesives may be obtained by transforming a material suitable as a TBDB adhesive (e.g. hydrogenated amorphous silicon [a:Si-H], and/or various polymers such as polyelectrolyte [iCVD], polyglycidylmethacrylate (PGMA), and polydimethylglutarimide [PMGI]) into a photopolymer. Photopolymers can be formed from prepolymers, oligomers, monomers, or mixtures thereof (hereinafter referred to as Photopolymer precursor or PPP), combined with materials added that interact with the PPP upon exposure to light to produce the desired cross-linking, or cleaving, depending on whether the patternable TBDB is implementing a negative or positive photoresist process, respectively. (For simplicity, and ease of discussion, the disclosure will focus on negative patterning, but different embodiments may also encompass positive patterning.)

For patternable TBDB, there are at least two types of photo-polymerization systems: autonomous reactant systems and complementary reactant systems. With autonomous reactant systems, multifunctional (e.g., low molecular weight monomers or oligomers) possessing polymerizable functional groups, X, undergo a photoinitiated radical, cationic, or anionic chain polymerization on irradiation to yield cross-linked network polymers. A photo-initiator, PI, is typically required. On the other hand, with complementary reactant systems, a photopolymer system may include two-components with each component bearing complementary reactive functional groups, X and Y. The reaction between X and Y results from the excitation of one of the groups by light or alternatively, it may occur through the mediation of a photo-initiator. For example, thiolene and thiolyne photopolymers can undergo facile cross-linking polymerization on irradiation in the presence of a free radical photoinitiator.

In some embodiments, suitable precursor mixtures may be synthesized from raw starter components or from existing TBDB adhesive solutions or mixtures thereof, modified with additives such as reactants, PI, solvents, and/or catalyst in order to control desired network properties. UV curable mixtures, depending on the type of photo-reacting crosslinking, generally include one or more PPPs (photo-polymer precursors).

PPPs comprise prepolymers, oligomers, reactive small molecules, multifunctional oligomers, or mixtures thereof. For example, because of their polyfunctionality, multifunctional oligomers enable network formation and dictation of the degree of crosslinking. Silicone based PPPs may be well suited for many patternable TBDB adhesives. for example, silicones with functional vinyl and hydrides may be used. Functional silicones, e.g., vinyl end-blocked silicone fluids provide reactive sites for cross-linking by ultraviolet (UV) accelerated free radical cross-linking. Functional vinyl silicones include many suitable compounds such as VOS (Vinylolysiloxane silicone), VPS (vinyl polysiloxane silicone), and PDMS (polydimethylsiloxane). VOS and VPS are typically used as impression materials but may be suitable with appropriate modification as a PPP to attain a patternable TBDB material. PDMS is a silicone elastomer commonly used for TBDB adhesives and are well suited as PPPs for patternable TBDB adhesive formulations.

Any suitable chemistry systems may be used to generate a patternable TBDB from these PPPs, depending on various factors including desired patterned structural integrity, post photo exposure, adhesive integrity once assembly components are attached to a carrier, solvents/Pls/development parameters that are desired to be employed, etc. For example, if a coordination based crosslinking is desired, epoxy chemistries using purpose built catalysts such as a Pt (platinum) catalyst could be used. Alternatively, if radical based photopolymerization is employed, other chemistries such as acrylate, N-vinyl urethane, and/or thiolene system chemistries (also with the use of Pt catalysts) could be used. Acrylates with their double bonds can readily facilitate crosslinking reactions. Common acrylated reactants include: acrylic acrylates, polyester acrylates, epoxy acrylates, urethane acrylates, amine modified polyether acrylates, and polyether acrylates. Thiolene systems may also work well, e.g., with functional vinyl-containing silicones, to create suitable patternable TBDB materials.

Fig. 4C shows an exemplary rection to create a patternable photo-polymer adhesive. "A" is a photoinitiator; in this case a radical initiator. "B" is a vinyl containing pre-polymer (telehelic end-capped as drawn, which could be side chain functionalized). "C" is thiol containing pre-polymer (side chain functional as drawn, which could be end-capped as well with Thiol). "D" is the resulting soft-cured network of B and C via A's photo initiation. With this example, A, B, and C may be mixed using a non-reactive solvent (such as cyclohexane). B and C may be loaded at a 1:1 mol. ratio of thiol to vinyl (which could be tuned for differences in crosslink density). A is loaded at modest loading (e.g., <10 wt.% of dry formulation). The solvent is used to target viscosity and spin coating compatibility. Post spin coating and slight drying may occur at 60 C for 1 min., with the carrier having been irradiated by 365 nm (suitable for the "A" type PI, although various other wavelengths could be used with a change in PI or polymerization mechanism).

IN this example, with a Pt catalyst (PI), a Thiolene chemistry is employed with the exemplary reaction shown in Fig. 4C for creating the patternable TBDB. Common Thiolene systems include: benzophenone, benzoin-ether, 2-dimethylaminoethanol (DMAE), hydroxyacetophenones, and 2-hydroxy-2-methyl-1-phenylpropan-1-one and, hydroxyl-phenyl-ketone.

Reactive diluents (e.g., monomers, multi-functional monomers, or oligomers), depending on the type of implemented photo-polymerization, can serve a reaction in one or some of various different ways. For example, a reactive diluent can act as a thinner to control the rheology of the liquid material and then react with the photoinitiator leading to the formation of the polymeric matrix and be used to modulate obtained thermomechanical and chemical performance of the obtained cross-linked network.

Photo-initiators are used to initiate the photopolymerization of PPPs and/or any associated reactants. The photoinitiator decomposes when it is activated by UV irradiation, thus leading to the formation of radical or cation/anion active species, which initiate the active monomers or oligomers in the reaction system. Thus, by exposing the polymeric mixture to a suitable UV light source (e.g., 365 nm, etc.) the liquid (e.g., viscous liquid) coating can be rapidly converted into a crosslinked coherent adhesive film that ins insoluble to a solvent used for pattern development for removing the unscanned resist.

For free radical initiation, Suitable photoinitiators (Pls) such as for Thiolene and acrylate curing may include but are not limited to Hydroxyketones (e.g., 1-Hydroxy-cyclohexyl-phenyl-ketone; 2-Hydroxy-2-methyl-1-phenyl-1-propanone); Phenylglyoxylates (e.g., Methylbenzoylformate, oxy-phenyl-acetic acid 2-[2 oxo-2, phenyl-acetoxy-ethoxy]-ethyl ester, oxy-phenyl-acetic 2[2-hydroxy-ethoxy]-ethyl ester); Aminoketones (e.g., 2-Benzyl-2-(dimethylamino)-1-[4-(4-morpholinyl) phenyl]-1-butanone, 2-Benzyl-2-(dimethylamino)-1-[4-(4-morpholinyl) phenyl]-1-butanone, 2-Methyl-1-[4-(methylthio)phenyl]-2-(4-morpholinyl)-1-propanone); Mono Acyl Phosphines (e.g., Diphenyl (2,4,6-trimethylbenzoyl)-phosphine oxide); and other groups such as Bis Acyl Phosphines;Phosphine oxides; Metallocene and lodonium salts.

For photo acid generators, e.g., for epoxy and cationic polymerizations, suitable PIs may include sulfonium and iodonium salts such as Triphenylsulfonium Hexafluoroantimonate, sulfonium HexafluoroantimonateT4013Triphenylsulfonium HexafluorophosphateD5990Diphenyl[4-(phenylthio)phenyl]sulfonium HexafluorophosphateH1776(4-Hydroxyphenyl)dimethylsulfonium Hexafluorophosphate, Triphenylsulfonium Hexafluoroantimonate, Diphenyl[4-(phenylthio)phenyl]sulfonium Hexafluoroantimonate, Triphenylsulfonium, Hexafluorophosphate, Diphenyl[4-(phenylthio)phenyl]sulfonium Hexafluorophosphate, (4-Hydroxyphenyl)dimethylsulfonium Hexafluorophosph ate, [4-(Octyloxy)phenyl](phenyl)iodonium Hexafluoroantimonate, [4-[(2-Hydroxytetradecyl)oxy]phenyl]phenyliodonium Hexafluoroantimonate, Bis(4-tert-butylphenyl)iodonium Hexafluoroantimonatel, and 4-Isopropyl-4'-methyldiphenyliodonium Tetrakis(pentafluorophenyl)borate.

Any suitable catalyst may be used. For example, with a silicone based adhesive precursor, a platinum based catalyst may be desired. For example, hydrosilylation reactions may be catalyzed by highly active platinum catalysts, such as the silicone-soluble Karstedt's catalyst. Suitable solvents may also be employed, e.g., to adjust solution viscosity for processability. It should be appreciated that for specific implementations, depending on utilized pre-polymer TBDB precursor materials and other considerations, prepolymer loading architectures and molecular weight facilities will likely be made. Along these lines, selection of particular photoinitiators will dictate the photon efficiency and the wavelength suitable for polymerization.

Next, at 300B (Fig. 4C), the coated carrier 455C is subjected to a desired pattern of UV radiation. For example, a patterned mask may be disposed over the surface to block light, so that only unmasked regions of the material will be exposed. In other embodiments, a pattern could be formed by scanning using a laser or even through electron beam scanning.

This process results in partial ("soft") curing of the TBDB adhesive, enough to adhere upon being developed but sufficiently malleable and adhering to secure assemblies until more rigidly fixed through a post-cure step. cutting edge UV sources and lithography materials are not required. For example, wavelengths of 365 nm, 405 nm, and 385 nm may be used. In one example, a 50 mW/cm2 projection at 365 nm was employed with a platinum UV active catalyst, which induced crosslinking of vinyl and hydride functionalized silicones in a silicone based TBDB adhesive. Whether laser or projector based light sources are employed, mm-dimension features, even with simple development solvents, may be achieved.

Fig. 4D is a top view of an exposed carrier 455D that has been developed. For development, a solvent, called a developer, is applied to the surface. In the case of a negative photoresist, the exposed photosensitive material portions are strengthened (e.g., cross-linked) by the UV radiation, and the developer dissolves away the regions that were not exposed to light, leaving behind a coating in areas where the mask was not placed.

With respect to Fig. 4D, a striped pattern was used. Developing with simple organic solvents removes non-irradiated adhesive. The radiation induced soft curing allows for the use of simple organic solvents such as ethyl cyclohexane or isopropanol. The developing solvent removes non-irradiated areas, leaving behind an exposed cavity layer 466 (e.g., release layer surface or glass surface). This is better seen in Fig. 4E, which is a side view of the carrier 455D. With the tuning of the exposure pattern (e.g., light source power, catalyst, or initiator loading) surface finish and obtainable cavity resolution may be modulated. As can be seen, with this example, the exposed portions 468 remain, while the unexposed portions 466 are washed away.

Fig. 3B and Figs. 4F-4H show a process for assembling an optical interconnect using a soft-cured patterned carrier in accordance with some embodiments. Die level entities are bonded onto the remaining adhesive surface portions to produce a reconned wafer map.

At 300D (Fig. 4F), an EIC 110 with hybrid contacts 422 shown on its upper surface is forced downward onto an adhesive portion 468 of the soft-cured carrier. (It is pointed out that this example shows one module being assembled but in an actual production process, several or even many modules may be assembled at the same time.)

From here, the carrier is baked to complete the remaining degree of cure in the adhesive material, mechanically locking the EIC units in place without voiding and shift during subsequent processes. For example, the carriers may be conveyed using adhesive rolls, nematic conveyors or other mechanisms. The hard cured adhesive serves to stabilize the EICs for subsequent assembly bonds, and it also protects the bump contacts on the EIC undersides.

Next, at 300E (Fig. 4G), the PIC 130/OC 120 is bonded, electrically and physically, to the upper surface of the EIC 110. The PIC has hybrid contacts 412, which are bonded with the hybrid contacts 422 of the EIC 110. As can be seen, the generated patterned cavity (or recess) 466 provides sufficient clearance for the OC without making contact with any part of the carrier, preventing it from being cracked or otherwise damaged.

Fig. 4H is a top view showing assembled modules 105 on the carrier wafer. Following assembly, traditional debond and cleaning flows to remove TBDB adhesive and yield suitable surfaces for subsequent packing are then performed. Specific debonding processes will depend on the utilized patternable TBDB adhesive and the assembly structures themselves. For example, thermal, laser, flood exposure, single layer laser releasee from a bottom layer (release layer) may be employed. For example, built-in release mechanisms, e.g., for laser ablation may be used. Layers or materials may be tuned for different release stimuli such as laser induced acoustics or nitrogen release. Fig. 4I shows a completed optical interconnect assembly after it has been de-bonded from the carrier.

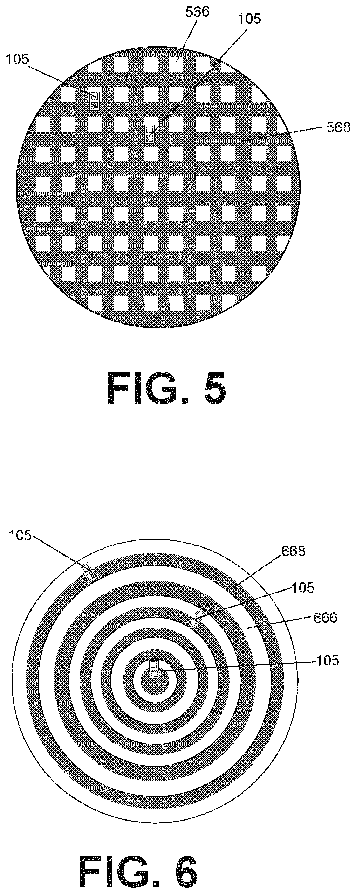

Figs. 5 and 6 show examples of other possible patterns that may be employed. Fig. 5 employs a checkerboard pattern with squares of soft-cured adhesive 568 and cavity (recess) portions 566 to accommodate over-hanging portions of assemblies 105. Fig. 6 is a top view showing an example of another possible pattern with concentric alternating rings of soft-cured adhesive 668 and cavity (recessed) portions 666 to accommodate overhang portions of the assemblies 105. (It should be appreciated that these diagrams are for explanation only and not necessarily drawn to scale.)

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

The term "circuit" or "module" may refer to one or more passive and/or active components that are arranged to cooperate with one another to provide a desired function. It should be

appreciated that different circuits or modules may consist of separate components, they may include both distinct and shared components, or they may consist of the same components. For example, A controller circuit may be a first circuit for performing a first function, and at the same time, it may be a second controller circuit for performing a second function, related or not related to the first function.

The meaning of "in" includes "in" and "on" unless expressly distinguished for a specific description.

The terms "substantially," "close," "approximately," "near," and "about," unless otherwise indicated, generally refer to being within +/-10% of a target value.

Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

It is pointed out that those elements of the figures having the same reference numbers (or names) as the elements of any other figure can operate or function in any manner similar to that described but are not limited to such.

While the flow diagrams in the figures show a particular order of operations performed by certain embodiments of the invention, it should be understood that such order is exemplary (e.g., alternative embodiments may perform the operations in a different order, combine certain operations, overlap certain operations, etc.).

## Claims

1. A fabrication process, comprising:
applying (300A) a TBDB, temporary bond de-bond, photopolymer adhesive to a carrier;
exposing (300B, 300C) the TBDB photopolymer to a UV or electron beam pattern to create soft-cured adhesive portions and recess portions where adhesive has been removed;
disposing (300D) first components onto the surfaces of the soft cured adhesive portions; and
mounting (300E, 300F) a separate second component onto each first component, wherein each second component has an over-hanging portion that is disposed within a proximal recess portion without contacting a carrier surface when the second components are mounted to the first components.

2. The process of claim 1, wherein each of said first components is an integrated circuit, IC, package having first electrical contacts on an underside of the package and second electrical contacts on an upper side of the package, wherein the first contacts are disposed into the adhesive prior to a bonding, post-cure operation.

3. The process of claim 2, wherein the second component is a photonic package having an attached optical coupler module that defines the overhanging portion, the photonic package having third electrical contacts connected to the second electrical contacts when the photonic package is mounted to the IC package, wherein the mounted together first and second packages constitute an optical interconnect module.

4. The process of claim 3, wherein the second and third contacts are hybrid contacts.

5. The process of claim 1 or claim 4, further comprising subjecting the carrier to a post-cure operation after disposing each of said first components onto the surfaces of the soft cured adhesive portions to further secure them.

6. The process of claim 5, wherein the post-cure operation comprises heating the carrier to a sufficient temperature for a sufficient time relative to the utilized TBDB photopolymer adhesive prior to mounting the second components onto the first components.

7. The process of claim 1 or claim 6, further comprising de-bonding the mounted together assemblies formed from the first and second components, said de-bonding including at least one of thermal slide, wet chemical dissolution, mechanical peeling and laser ablation.

8. The process of claim 7, wherein applying a TBDB photopolymer adhesive to a carrier includes applying the adhesive atop a release layer for assembly removal via laser ablation.

9. The process of claim 1 or claim 8, wherein the TBDB photopolymer adhesive is formed from a silicone based adhesive having one or more photoinitiators.

10. The process of claim 9, wherein the silicone based adhesive includes a platinum catalyst.

11. The process of claim 9, wherein the photo-polymer adhesive uses a radical based photoinitiation system to create a soft-cured cross-linked network.

12. The process of claim 11, wherein the radical based system employs a thiolene as a reactant.

13. The process of claim 9, wherein the adhesive includes a coordination-based photo-catalyst to facilitate photo curing of functional silicones bearing vinyl and hydride units.

14. A machine to perform the process of any one of claims 1 to 13.

15. An apparatus made using a process in accordance with the process of any one of claims 1 to 13.

## Patentansprüche

1. Fertigungsprozess, umfassend:
Aufbringen (300A) eines temporären Bond-und-Debond-Photopolymerklebstoffs, TBDB-Photopolymerklebstoffs, auf einen Träger;
Freilegen (300B, 300C) des TBDB-Photopolymers für eine UV- oder Elektronenstrahlstruktur, um vorangehärtete Klebstoffabschnitte und Vertiefungsabschnitte zu erzeugen, wo der Klebstoff entfernt wurde;
Anordnen (300D) von ersten Komponenten auf den Oberflächen der vorangehärteten Klebstoffabschnitte; und
Montieren (300E, 300F) einer separaten zweiten Komponente auf jede erste Komponente, wobei jede zweite Komponente einen überhängenden Abschnitt aufweist, der innerhalb eines proximalen Vertiefungsabschnitts angeordnet ist, ohne eine Trägeroberfläche zu berühren, wenn die zweiten Komponenten auf die ersten Komponenten montiert sind.

2. Prozess nach Anspruch 1, wobei jede der ersten Komponenten ein Gehäuse einer integrierten Schaltung, IC-Gehäuse, ist, das erste elektrische Kontakte an einer Unterseite des Gehäuses und zweite elektrische Kontakte an einer Oberseite des Gehäuses aufweist, wobei die ersten Kontakte vor einer Bond-Temperoperation in dem Klebstoff angeordnet werden.

3. Prozess nach Anspruch 2, wobei die zweite Komponente ein photonisches Gehäuse ist, das ein daran befestigtes optisches Kopplermodul aufweist, das den überhängenden Abschnitt definiert, wobei das photonische Gehäuse dritte elektrische Kontakte aufweist, die mit den zweiten elektrischen Kontakten verbunden sind, wenn das photonische Gehäuse an das IC-Gehäuse montiert ist, wobei das erste und das zweite Gehäuse zusammengebaut ein optisches Zwischenverbindungsmodul bilden.

4. Prozess nach Anspruch 3, wobei die zweiten und die dritten Kontakte Hybridkontakte sind.

5. Prozess nach Anspruch 1 oder Anspruch 4, der ferner umfasst, dass der Träger nach dem Anordnen von jeder der ersten Komponenten auf den Oberflächen der vorangehärteten Klebstoffabschnitte, für ein zusätzliches Befestigen, einer Temperoperation unterzogen wird.

6. Prozess nach Anspruch 5, wobei die Temperoperation, vor dem Montieren der zweiten Komponenten auf die ersten Komponenten, ein Erwärmen des Trägers auf eine ausreichende Temperatur für eine ausreichende Zeit relativ zu dem verwendeten TBDB-Photopolymerklebstoff umfasst.

7. Prozess nach Anspruch 1 oder Anspruch 6, der ferner ein Debonden der zusammengebauten Baugruppen umfasst, die aus der ersten und der zweiten Komponente gebildet werden, wobei das Debonden mindestens eines von einem thermischem Gleitablösen, einer nasschemischer Auflösung, einem mechanischen Ablösen und einer Laserablation umfasst.

8. Prozess nach Anspruch 7, wobei das Aufbringen eines TBDB-Photopolymerklebstoffs auf einen Träger ein Aufbringen des Klebstoffs oben auf eine Ablöseschicht für eine Baugruppenentfernung durch eine Laserablation aufweist.

9. Prozess nach Anspruch 1 oder Anspruch 8, wobei der TBDB-Photopolymerklebstoff aus einem silikonbasierten Klebstoff gebildet ist, der einen oder mehrere Photoinitiatoren aufweist.

10. Prozess nach Anspruch 9, wobei der silikonbasierte Klebstoff einen Platinkatalysator aufweist.

11. Prozess nach Anspruch 9, wobei der Photopolymerklebstoff ein radikalbasiertes Photoinitiierungssystem verwendet, um ein vorangehärtetes vernetztes Netzwerk zu erzeugen.

12. Prozess nach Anspruch 11, wobei das radikalbasierte System ein Thiol als ein Reaktionsmittel einsetzt.

13. Prozess nach Anspruch 9, wobei der Klebstoff einen koordinationsbasierten Photokatalysator aufweist, um eine Photohärtung von funktionellen Silikonen, die Vinyl- und Hydrideinheiten tragen, zu vereinfachen.

14. Maschine zum Durchführen des Prozesses nach einem der Ansprüche 1 bis 13.

15. Vorrichtung, die unter Verwendung eines Prozesses gemäß dem Prozess nach einem der Ansprüche 1 bis 13 gefertigt wird.

## Revendications

1. Procédé de fabrication comprenant :
l'application (300A) d'un adhésif photopolymère de collage et décollage temporaire, TBDB, sur un support ;
l'exposition (300B, 300C) du photopolymère TBDB à un rayonnement UV ou à un motif de faisceau d'électrons pour créer des parties adhésives partiellement durcies et des parties évidées dans lesquelles l'adhésif a été retiré ;
la disposition (300D) de premiers composants sur les surfaces des parties d'adhésif partiellement durcies ; et
le montage (300E, 300F) d'un deuxième composant séparé sur chaque premier composant, chaque deuxième composant présentant une partie en porte-à-faux qui est disposée à l'intérieur d'une partie évidée proximale sans contact avec une surface de support lorsque les deuxièmes composants sont montés sur les premiers composants.

2. Procédé selon la revendication 1, dans lequel chacun desdits premiers composants est un boîtier à circuit intégré, IC, ayant des premiers contacts électriques sur une face inférieure du boîtier et des deuxièmes contacts électriques sur une face supérieure du boîtier, les premiers contacts étant disposés dans l'adhésif avant une opération de collage, post-durcissement.

3. Procédé selon la revendication 2, dans lequel le deuxième composant est un boîtier photonique auquel est fixé un module coupleur optique qui définit la partie en porte-à-faux, le boîtier photonique ayant des troisièmes contacts électriques connectés aux deuxièmes contacts électriques lorsque le boîtier photonique est monté sur le boîtier IC, les premier et deuxième boîtiers montés ensemble constituant un module d'interconnexion optique.

4. Procédé selon la revendication 3, dans lequel les deuxième et troisième contacts sont des contacts hybrides.

5. Procédé selon la revendication 1 ou la revendication 4, comprenant en outre l'étape consistant à soumettre le support à une opération de post-durcissement après avoir disposé chacun desdits premiers composants sur les surfaces des parties adhésives partiellement durcies pour les fixer davantage.

6. Procédé selon la revendication 5, dans lequel l'opération de post-durcissement comprend le chauffage du support à une température suffisante pendant un temps suffisant par rapport à l'adhésif photopolymère TBDB utilisé avant le montage des deuxièmes composants sur les premiers composants.

7. Procédé selon la revendication 1 ou la revendication 6, comprenant en outre le décollage des ensembles montés ensemble formés à partir des premier et deuxième composants, ledit décollage comprenant au moins l'une des opérations suivantes : glissement thermique, dissolution chimique humide, pelage mécanique et ablation au laser.

8. Procédé selon la revendication 7, dans lequel l'application d'un adhésif photopolymère TBDB sur un support comprend l'application de l'adhésif au-dessus d'une couche de séparation pour l'enlèvement de l'ensemble par ablation laser.

9. Procédé selon la revendication 1 ou la revendication 8, dans lequel l'adhésif photopolymère TBDB est formé à partir d'un adhésif à base de silicone ayant un ou plusieurs photoinitiateurs.

10. Procédé selon la revendication 9, dans lequel l'adhésif à base de silicone comprend un catalyseur au platine.

11. Procédé selon la revendication 9, dans lequel l'adhésif photopolymère utilise un système de photoinitiation radicalaiires pour créer un réseau réticulé partiellement durci.

12. Procédé selon la revendication 11, dans lequel le système radicalaire utilise un thiolène comme réactif.

13. Procédé selon la revendication 9, dans lequel l'adhésif comprend un photocatalyseur à base de coordination pour faciliter le photodurcissement de silicones fonctionnelles portant des unités vinyle et hydrure.

14. Machine pour l'exécution du procédé selon l'une quelconque des revendications 1 à 13.

15. Appareil fabriqué en utilisant un procédé conforme au procédé selon l'une quelconque des revendications 1 à 13.
